# EUROPÄISCHE PATENTANMELDUNG

(11) **EP 1 803 789 A1**
(43) Veröffentlichungstag der Anmeldung: **04.07.2007**
(21) Anmeldenummer: 05028570.9
(22) Anmeldetag: 28.12.2005
(51) Int. Cl.: C09K 11/06

(54) **Verwendung von Metallkomplexen als Emitter in einem elektronischen Bauelement und elektronisches Bauelement**

(71) Anmelder: Novaled AG, 01307 Dresden (DE)
(72) Erfinder: Hartmann, Horst, 01326 Dresden (DE); Yersin, Hartmut, 93161 Sinzing (DE)
(74) Vertreter: Bittner, Thomas L.

(57) **Zusammenfassung**

Die vorliegende Erfindung betrifft die Verwendung von Metallkomplexen mit 2-(3-Thienyl)-Pyridin-Liganden als Emitter in organischen lichtemittierenden Bauelementen, wobei die Komplexe durch die Formeln (1) und (2) beschrieben werden, sowie ein solches Bauelement.

## Beschreibung

Die Erfindung betrifft die Verwendung von Metallkomplexen als Emitter in einem elektronischen Bauelement und dieses elektronische Bauelement.

Bekanntermaßen stellen elektrolumineszierende Verbindungen das Herzstück organischer Leuchtdioden dar. Sie werden im allgemeinen eingebettet in oder chemisch gebunden an monomere, oligomere oder polymere Materialien, die in der Regel so beschaffen sind, daß in ihnen geeignete Ladungsträger erzeugt und transportiert werden können mit der Maßgabe, daß beim Zusammentreffen gegensätzlich geladener Ladungsträger Excitonen gebildet werden, die ihre Überschußenergie auf die jeweilige elektrolumineszierende Verbindung übertragen. Diese elektrolumineszierende Verbindung kann daraufhin in einen bestimmten elektronischen Anregungszustand übergehen, der dann möglichst vollständig und unter Vermeidung strahlungsloser Deaktivierungsprozesse durch Lichtemission in den zugehörigen Grundzustand umgewandelt wird. Als elektronischer Anregungszustand, der auch durch Energieübertragung von einem geeigneten Vorläufer-Exciton gebildet werden kann, kommt, von wenigen Ausnahmen abgesehen, entweder ein Singulett- oder Triplett-Zustand in Betracht. Da beide Zustände aufgrund der Spinstatistik in der Regel im Verhältnis 1:3 besetzt werden, ergibt sich, daß bei einer Emission aus dem Singulett-Zustand, die als Fluoreszenz bezeichnet wird und hauptsächlich bei organischen, schwermetallfreien Verbindungen auftritt, nur maximal 25% der übernommenen Anregungsenergie wieder emittiert werden kann. Dagegen kann bei einer Triplett-Emission, die als Phosphoreszenz bezeichnet wird und vornehmlich bei Übergangsmetallorganyl-Verbindungen auftritt, der gesamte Betrag der übernommenen Anregungsenergie wieder emittiert werden (Triplett-Harvesting), so dass in diesem Fall die Lichtausbeute den Wert von 100% erreichen kann, sofern sich der simultan mitgebildete und energetisch über dem Triplett-Zustand liegende Singulett-Zustand mit emittiert, sich vollständig in den Triplett-Zustand umwandelt und strahlungslose Konkurrenzprozesse bedeutungslos bleiben. Somit sollten Triplett-Emitter grundsätzlich effizientere Luminophore sein, die dazu geeignet sind, in einer organischen Leuchtdiode für eine hohe Lichtausbeute zu sorgen.

Wie die Erfahrung zeigt, sind bisher trotz intensiver Suche nach hocheffizienten Triplett-Emittem nur sehr wenige Verbindungen bekannt geworden, deren Lichtausbeute an die Grenze von 100% heranreicht, da fast immer strahlungslose Konkurrenzprozesse simultan mit der gewünschten Phosphoreszenz ablaufen. Bei den bisher bekannt gewordenen hocheffizienten Triplett-Emittern handelt sich zumeist um Komplexe einiger vorwiegend aus den Gruppen 6-10 des Periodischen Systems stammender Schwermetalle mit bestimmten, vorwiegend π-elektronenhaltigen Liganden, wobei diese meist sowohl über Haupt- und Nebenvalenzen an das jeweilige Schwermetall gebunden sind. Es hat sich dabei gezeigt, dass bei den genannten Komplexen die Art und Stärke der Metall-Ligand-Bindungen einen entscheidenden Einfluss auf das Wechselspiel zwischen strahlungsloser und strahlender Desaktivierung und damit auf die jeweils erzielbare Lumineszenzquantenausbeute besitzt, dass diese Größen aber kaum für eine bestimmte Verbindung eindeutig voraussagbar sind.

In der DE 102 51 986 A1 werden hocheffiziente Triplett-Emitter beansprucht, die aus einem zentralen Schwermetallatom, wie Iridium oder Platin, bestehen, das mit einer unterschiedlichen Anzahl verschiedener 2-Aryl- bzw. 2-Heteroarylpyridinen sowie teilweise mit weiteren bi- oder monodentaten Liganden komplexiert wurde, wobei unter den beanspruchten 2-Heteroarylpyridinen besonders das 2-(2-Thienyl)-pyridin als Ligand explizit erwähnt wird. Doch wird nicht im einzelnen gezeigt, welchen Vorteil die Verwendung dieses Ligandentyps gegenüber den weiteren offenbarten Liganden besitzt. Detaillierte spektroskopische Daten über Verbindungen des genannten Strukturtyps wurden von H. Yersin und D. Douges in Topics in Curr. Chem. 2001, 214, 81 veröffentlicht.

Der vorliegenden Erfindung liegt die Aufgabe zugrunde, die Nachteile des Stands der Technik zu überwinden, insbesondere elektronische Bauelemente bereitzustellen, die hocheffiziente Emitterverbindungen einsetzen können. Insbesondere soll bei Verwendung entsprechender Verbindungen eine hohe Lumineszenzquantenausbeute erreichbar sein, mit denen sich insbesondere organische Leuchtdioden mit hoher Strahlungsleistung konstruieren lassen.

Diese Aufgabe wird gelöst durch die Verwendung eines Metallkomplexes mit 2-(3-Thienyl)-Pyridin-Liganden als Emitter in einem elektronischen Bauelement, wobei der Metallkomplex die allgemeine Formel **1** oder **2** aufweist: 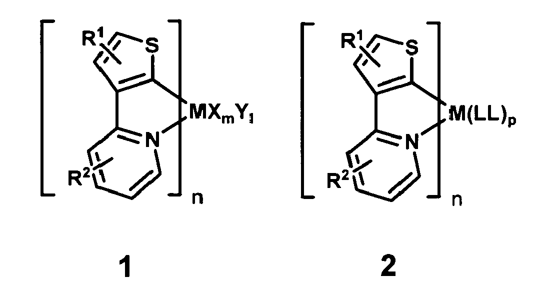 wobei M ein Schwermetall ist, X, Y und LL Liganden sind, die unabhängig voneinander geladen oder ungeladen sind und von denen im wesentlichen keine Emission ausgeht, R¹ und R² unabhängig voneinander einfach oder mehrfach an dem jeweiligen Zyklus vorliegen können und unabhängig ausgewählt werden aus F, Cl, Br, I, NO₂, CN, einer geradkettigen oder verzweigten oder zyklischen Alkyl- oder Alkoxygruppe mit 1 bis 20 Kohlenstoffatomen, wobei eine oder mehrere nicht-benachbarte CH₂-Gruppen durch -O-, -SiR³₂-, -S-, -NR³- oder -CONR³- ersetzt sein können und wobei ein oder mehrere H-Atome durch F ersetzt sein können, oder eine Aryl- oder Heteroaryl-Gruppe mit 4 bis 14C-Atomen, die durch einen oder mehrere, nicht aromatische Reste R¹ oder R² substituiert sein kann; wobei mehrere Substituenten R¹ bzw. R², sowohl am selben Ring als auch an den beiden unterschiedlichen Ringen, zusammen wiederum ein weiteres mono- oder polyzyklisches Ringsystem aufspannen können; R³ gleich oder verschieden ist bei jedem Auftreten und ausgewählt ist aus H oder einem aliphatischen oder aromatischen Kohlenwasserstoffrest mit 1 bis 20 Kohlenstoffatomen; n=1-3 ist, m und 1 unabhängig voneinander 0-4 mit 2n+m+1=4 bzw. 6 sind oder p = 0-2 mit 2n+2p=4 bzw. 6 ist.

Die Liganden X, Y und LL sind solche, von denen im wesentlichen keine Emission ausgeht, die aber die Emissionswellenlängen, Emissionsdauern und Emissionsquantenausbeuten sowie die Stabilität der resultierenden Komplexe wesentlich beeinflussen.

Durch bestimmte Ligandenkombinationen können auch negativ geladene Komplexe der Form [(3-Thienylpyridin)ₙMXₘY₁]^{q-} und [(3-Thienylpyridin)ₙM(LL)ₚ]^{r-} entstehen. Zum Ausgleich der Ladung können Metallkationen Me^{s+} (s = 1-3) sowie Ammonium- und PhosphoniumSalze zum Einsatz kommen. Die negativ geladenen Komplexe sollen im Rahmen der vorliegenden Erfindung in den oben gezeigten Formen 1 und 2 eingeschlossen sein.

Besonders bevorzugt ist vorgesehen, daß das Schwermetall ausgewählt wird aus Pt(II), Pt(IV), Re(I), Os(II), Ru(II), Ir(I), Ir(III), Au(I), Au(III), Hg(I), Hg(II) und Cu(I).

In einer weiteren Ausführungsform ist vorgesehen, daß X und Y unabhängig voneinander einfach negativ geladene Liganden oder neutrale einzähnige Liganden sind.

Dabei ist vorgesehen, daß X und Y unabhängig voneinander ausgewählt werden aus F⁻, Cl⁻, Br⁻, I⁻, CN⁻, NCO⁻, SCN⁻, R⁴S⁻, R⁴O⁻, R⁴C=C⁻, R⁴COO⁻, NO₃⁻, Amin, Phosphan, Arsan, Nitril, Isonitril, CO, Carben, Ether und Thioether, wobei R⁴ ein organischer Rest mit 1 bis 15 Kohlenstoffatomen ist, vorzugsweise Alkyl.

In einer weiteren Ausführungsform der Erfindung ist LL, vorzugsweise einfach negativ geladen, ein chelatisierender Ligand und/oder ein cyclometallierender Ligand.

Besonders bevorzugt ist es dabei daß LL ausgewählt wird aus β-Diketonat, β-Diketoiminat, [(Pyrazolyl)₂H]⁻, [(Pyrazolyl)₂BR⁵₂]⁻, [Pyrazolyl₃BH]⁻, [Pyrazolyl₄B]⁻, (Triazolyl)₂BH₂⁻, (Triazolyl)₃BH⁻, (Triazolyl)₄B⁻, (Ph₂PCH₂)₂BR⁵₂⁻, R⁵COO⁻, NO₃⁻, Diamin, Diphosphan, Diarsan, Dinitril, Diisonitril, Dialkylether und Dialkyl(thio)ether, wobei R⁵ ein organischer Rest mit 1-15 Kohlenstoffatomen ist, vorzugsweise Alkyl.

Bevorzugt wird der Metallkomplex als Triplett-Emitter eingesetzt.

Erfindungsgemäß ist auch ein elektronisches Bauelement, welches einen Metallkomplex enthält, wie er oben beschrieben wurde.

Es ist bevorzugt ein elektronisches Bauelement in Form einer organischen lichtemittierenden Diode (OLED) vorgesehen.

Weiter ist dabei ein elektronisches Bauelement vorgesehen, wobei die organische lichtemittierende Diode den Komplex in einer Elektronentransportschicht in einer Konzentration von 2-20 Gewichtsprozent, vorzugsweise 5-8 Gewichtsprozent enthält.

Überraschenderweise wurde festgestellt, daß durch die Verwendung der beschriebenen Schwermetallkomplexe mit 2-(3-Thienyl)-pyridin-Liganden insbesondere in organischen Leuchtdioden deutlich verbesserte Lumineszenzquantenausbeuten möglich werden und somit die Strahlungsleistung der organischen Leuchtdioden erhöht werden kann. Weitere Vorteile der beschriebenen Schwermetallkomplexe bestehen in ihrer guten Sublimierbarkeit sowie in der Möglichkeit, durch strukturelle Variationen an den Organyl-Liganden die Emissionsbereiche und damit die wahrnehmbaren Farben der lichemittierenden Dioden in weiten Bereichen zu variieren.

Die als Emitter verwendeten Metallkomplexe des allgemeinen Formeltyps **1** und **2** können auf an sich bekannte Weise hergestellt werden, indem von einer geeigneten Schwermetallverbindung, wie einem Schwermetallhalogenid, einem Schwermetallacetat oder einem Schwermetallnitrat, ausgegangen wird und diese Verbindung entweder direkt mit 2-(3-Thienyl)-pyridin oder nach dessen vorhergehender Aktivierung in Form einer geeigneten Alkalimetallverbindung oder einer seiner daraus zugänglichen metallorganischen Derivate, wie einer Trialkylstannyl-, Alkylcupryl- oder Alkylzinkat-Verbindung, umgesetzt werden. Je nach Art der eingesetzten Ausgangskomponenten, der angewandten Reaktionsbedingungen und des jeweiligen stöchiometrischen Verhältnisses der einzelnen Komponenten entstehen dabei Komplexe, die durch dieses besondere Strukturmerkmal eine außergewöhnlich hohe Phosphoreszenz-Quantenausbeute besitzen.

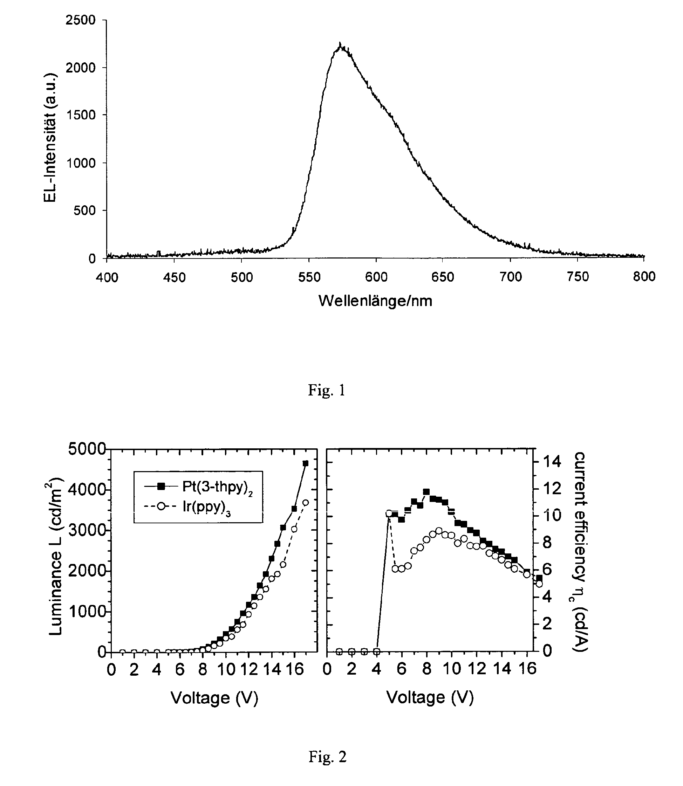

Die vorliegende Erfindung wird nunmehr anhand einer detaillierten Beschreibung eines Ausführungsbeispiels in Verbindung mit der beigefügten Zeichnung näher beschrieben, in welcher Figur 1 ein Elektrolumineszenzspektrum eines elektronischen Bauelements zeigt, in welchem ein entsprechender Metallkomplex erfindungsgemäß verwendet worden ist; und

Figur 2 Luminanz- und Effizienz-Charakteristika eines solchen Bauelements und eines Bauelements, das [Ir(ppy)₃] als Emitter verwendet, zeigt.

### Beispiel

Die Verbindung Pt(3-thienylpyridin)₂ wurde nach den Angaben von L. Chassot und A. von Zelewsky in Inorganic Chemistry 1987, 26, 2814 aus trans-PtCl₂(SEt)₂ und zwei Äquivalenten des lithiierten 2-(3-Thienyl)-pyridins hergestellt. Die Verbindung ist ein tief rot gefärbter, im roten Spektralbereich mit einem Maximum bei ca. 600 nm intensiv lumineszierender, thermisch bis ca. 300°C stabiler und damit im Hochvakuum unversetzt verdampfbarer Feststoff.

Organische Leuchtdioden der folgenden Konfiguration wurden aufgebaut und deren Eigenschaften getestet.

Auf eine mit einer 50 nm dicken ITO-Schicht versehenen Glasunterlage wurde nacheinander eine 100 nm dicke, mit 2% 2,3,5,6-Tetrafluor-7,7,8,8-tetracyano-chinodimethan (F₄-TCNQ) dotierte Schicht von 4,4',4"-Tris-[Phenyl-(3-tolyl)-amino]-triphenylamin (mMTDATA), eine 20 nm dicke, mit 7% Pt(3-thienylpyridin)₂ dotierte Schicht von 4,4',4"-Tris-(N-carbazolyl)-triphenylamin (TCTA), eine 40 nm dicke Schicht von 3-(4-Biphenyl)-4-phenyl-5-tert.-butylphenyl-1,2,4-triazol (TAZ), eine 0,5 nm dicke Schicht Lithiumflorid und schließlich eine Aluminiumelektrode aufgedampft.

Das von dem auch vorstehend in seinem Aufbau beschriebene Bauelement gemessene Elektrolumineszenzspektrum ist in Figur 1 wiedergegeben und besitzt mit einer Leistungseffizienz von 4.00 lm/Watt eine Quanteneffizienz von etwa 4%. In Figur 2 sind die Luminanz- und Effizienz-Charakteristika des vorstehend beschriebenen OLED-Bauelements wiedergegeben. Diese Daten wurden einem Bauelement gegenübergestellt, das nach der gleichen Vorgehensweise präpariert wurde, jedoch anstelle des Pt(3-thienylpyridin)₂-Emitters Iridiumtrisphenylpyridin [Ir(ppy)₃] als Emitter enthält. Aus Figur 2 ergeben sich deutlich die Vorteile bei der erfindungsgemäßen Verwendung der Schwermetallkomplexe mit 2-(3-Thienylpyridin)-Liganden.

Die in der vorstehenden Beschreibung, den Ansprüchen und der Zeichnung offenbarten Merkmale können sowohl einzeln als auch in jeder beliebigen Kombination zur Verwirklichung der Erfindung in ihren unterschiedlichen Ausführungsformen wesentlich sein.

## Patentansprüche

1. Verwendung eines Metallkomplexes mit 2-(3-Thienyl)-Pyridin-Liganden als Emitter in einem organischen lichtemittierenden Bauelement, wobei der Metallkomplex die allgemeine Formel **1** oder **2** aufweist: 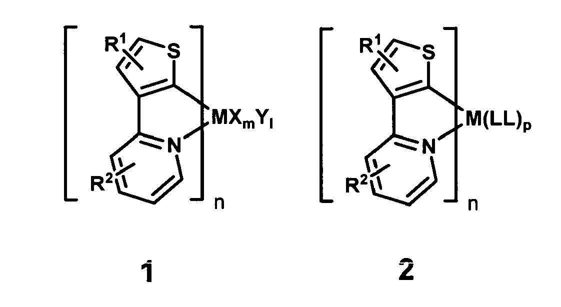 wobei M ein Schwermetall ist, X, Y und LL Liganden sind, die unabhängig voneinander geladen oder ungeladen sind und von denen im wesentlichen keine Emission ausgeht, R¹ und R² unabhängig voneinander einfach oder mehrfach an dem jeweiligen Zyklus vorliegen können und unabhängig ausgewählt werden aus F, Cl, Br, I, NO₂, CN, einer geradkettigen oder verzweigten oder zyklischen Alkyl- oder Alkoxygruppe mit 1 bis 20 Kohlenstoffatomen, wobei eine oder mehrere nicht-benachbarte CH₂-Gruppen durch -O-, -SiR³₂-, -S-, -NR³- oder -CONR³- ersetzt sein können und wobei ein oder mehrere H-Atome durch F ersetzt sein können, oder eine Aryl- oder Heteroaryl-Gruppe mit 4 bis 14 C-Atomen, die durch einen oder mehrere, nicht aromatische Reste R¹ oder R² substituiert sein kann; wobei mehrere Substituenten R¹ bzw. R², sowohl am selben Ring als auch an den beiden unterschiedlichen Ringen, zusammen wiederum ein weiteres mono- oder polyzyklisches Ringsystem aufspannen können ; R³ gleich oder verschieden ist bei jedem Auftreten und ausgewählt ist aus H oder einem aliphatischen oder aromatischen Kohlenwasserstoffrest mit 1 bis 20 Kohlenstoffatomen; n=1-3 ist, m und 1 unabhängig voneinander 0-4 mit 2n+m+1=4 bzw. 6 sind oder p=0-2 mit 2n+2p=4 bzw. 6 ist.

2. Verwendung nach Anspruch 1, **dadurch gekennzeichnet, daß** das Schwermetall ausgewählt wird aus Pt(II), Pt(IV), Re(I), Os(II), Ru(II), Ir(I), Ir(III), Au(I), Au(III), Hg(I), Hg(II) und Cu(I).

3. Verwendung nach Anspruch 1 oder 2, **dadurch gekennzeichnet, daß** X und Y unabhängig voneinander einfach negativ geladene Liganden oder neutrale einzähnige Liganden sind.

4. Verwendung nach Anspruch 3, **dadurch gekennzeichnet, daß** X und Y unabhängig voneinander ausgewählt werden aus F⁻, Cl⁻, Br⁻, I⁻, CN⁻, NCO⁻, SCN⁻, R⁴S⁻, R⁴O⁻, R⁴C=C⁻, R⁴COO⁻, NO₃⁻, Amin, Phosphan, Arsan, Nitril, Isonitril, CO, Carben, Ether und Thioether, wobei R⁴ ein organischer Rest mit 1 bis 15 Kohlenstoffatomen ist, vorzugsweise Alkyl.

5. Verwendung nach einem der vorangehenden Ansprüche, **dadurch gekennzeichnet, daß** LL, vorzugsweise einfach negativ geladen, ein chelatisierender Ligand und/oder ein cyclometallierender Ligand ist.

6. Verwendung nach Anspruch 5, **dadurch gekennzeichnet, daß** LL ausgewählt wird aus β-Diketonat, β-Diketoiminat, [(Pyrazolyl)₂H]⁻, [(Pyrazolyl)₂BR⁵₂]⁻, [Pyrazolyl₃BH]⁻, [Pyrazolyl₄B]⁻, (Triazolyl)₂BH₂⁻, (Triazolyl)₃BH⁻, (Triazolyl)₄B⁻, (Ph₂PCH₂)₂BR⁵₂⁻, R⁵COO⁻, NO₃⁻, Diamin, Diphosphan, Diarsan, Dinitril, Diisonitril, Dialkylether und Dialkyl(thio)ether, wobei R⁵ ein organischer Rest mit 1-15 Kohlenstoffatomen ist, vorzugsweise Alkyl.

7. Verwendung nach einem der vorangehenden Ansprüche, **dadurch gekennzeichnet, daß** der Metallkomplex als Triplett-Emitter eingesetzt wird.

8. Elektronisches Bauelement, welches einen Metallkomplex enthält, wie er gemäß Anspruch 1 definiert wird.

9. Elektronisches Bauelement nach Anspruch 8, in Form einer organischen lichtemittierenden Diode (OLED).

10. Elektronisches Bauelement nach Anspruch 9, **dadurch gekennzeichnet, daß** die organische lichtemittierende Diode den Komplex in einer Konzentration von 2-20 Gewichtsprozent, vorzugsweise 5-8 Gewichtsprozent enthält.
